# EUROPEAN PATENT APPLICATION

(11) **EP 3 598 465 A1**
(43) Date of publication of application: **22.01.2020**
(21) Application number: 18183590.1
(22) Date of filing: 16.07.2018
(51) Int. Cl.: H01G 9/20, H02J 7/35, H01L 31/0203, H02M 3/00, H02S 40/38

(54) **PHOTOVOLTAIC CELL WITH FIBER MESH SUPPORT AND CHARGER FOR PORTABLE ELECTRONICS**

(71) Applicant: Exeger Operations AB, 102 04 Stockholm (SE)
(72) Inventor: Lindström, Henrik, 184 63 Åkersberga (SE); Fili, Giovanni, 182 56 Danderyd (SE)
(74) Representative: Swea IP Law AB

(57) **Abstract**

The present invention relates to a photovoltaic charger (1) specially adapted for charging an electronic device, comprising a solar cell unit (2) comprising a working electrode comprising a porous light-absorbing layer (10) including dyed TiO₂, a porous first conducting layer (12) for extracting photo-generated electrons from the light-absorbing layer (10), wherein the light-absorbing layer is arranged on top of the first conducting layer, a porous substrate (14) made of an insulating material and extending through the entire solar cell unit, wherein the first conducting layer (12) is formed on one side of the porous substrate (14), a counter electrode including a second conducting layer (16), wherein the second conducting layer is formed on the opposite side of the porous substrate (14), and a conducting medium for transferring charges between the counter electrode and the light-absorbing layer, a encapsulation (5) enclosing the solar cell unit, a first conductor (18) electrically connected to the first conducting layer (12), and at least one second conductor (20) electrically connected to the second conducting layer (16). The photovoltaic charger contains only one single solar cell unit (2) and a boost converter (22) electrically connected to the first and second conductors (12, 16), and the boost converter is adapted to step up the voltage from the solar cell unit while stepping down the current from the solar cell unit.

## Description

### Technical field

The present invention relates to a photovoltaic charger specially adapted for charging an electronic device, use of the photovoltaic charger, and a method for producing the photovoltaic charger.

### Background

Solar cells have been used during a long time for converting the energy of light into electricity. A solar panel contains multiple solar cells connected in series, and is used to absorb sunlight as a source of energy to generate electricity. A large number of solar panels are often arranged together in large solar parks for producing electricity to an electricity supply network.

Solar cells are becoming more and more efficient as well as cheaper to produce. So, naturally, companies are making all sorts of consumer products powered at least in part by solar cells. Many portable electronic devices are today provided with built-in rechargeable batteries which store energy, and photovoltaic chargers arranged to supply power to the batteries for charging them. A photovoltaic charger or a solar charger employs solar energy to supply electricity to the devices and to charge batteries. Examples of such portable devices are tablets, mobile phones, head phones and calculators. When solar cells are used, the battery of the device is complemented so that the use time is increased before there is a need to charge the device from an external source. Depending on the efficiency of the photovoltaic charger and the power consumption of the device, the need for charging the device with an external source may even be obsoleted and the device is then only powered by solar power. For example, small calculators are often powered solely by photovoltaic chargers.

Photovoltaic chargers on the market today use various types of solar panels, ranging from thin film panels with efficiencies ranging from 7-15%, to the slightly more efficient monocrystalline panels which offer efficiencies up to 18%. The efficiency is usually tested using Standard Testing Conditions, STC, which is the industry standard for the conditions under which solar panels are tested. In the STC, the irradiation is 1000 W/m², the temperature is 25°C and the Air Mass is 1.5. As an example, a solar panel giving an output power of 200 W/m² has an efficiency of 20%. These conditions simulate what the efficiency of a solar panel is in outside conditions on a summer day with no clouds. The wavelength spectrum of indoor light differs from the wavelength spectrum of outdoor light. For example, wavelengths outside the visible range is often missing in indoor light since glass windows filter UV light and indoor lamps mainly produce light in the visible range. Thus, the efficiency of a solar panel measured in outside conditions cannot be applied to indoor conditions. The typical human eye will respond to wavelengths from about 390 to 700 nm, and indoor light is mostly within the visible spectrum.

In the article "Comparison of the indoor performance of 12 commercial PV products by a simple model" by Georgia Apostolou et al. it is explained how indoor lighting differs from outdoor lighting. The author of the article states that in case of a double-glass insulated window, the decrease in the radiant power at 1 and 5 m from the window will be around 70% and 97%, respectively. The article shows that solar panels today lose a lot of their efficiency in indoor lighting. Hence, a disadvantage with those solar panels is that they have low efficiency at low light intensities.

Other disadvantages with existing solar cell panels for powering electronic devices are that some of them are toxic, have bad mechanical properties and are expensive.

GB2510451(A) by OnBeat Ltd. shows a pair of head phones powered by solar cells. A flexible solar panel is provided on the outer surface of the headband and on the earpieces. The head phones can also be used to power an external device with stored solar power. It is visually apparent to the onlooker that the OnBeat headband is covered by a panel of solar cells, but the type of solar cell is not specified.

Battery Just In Case™ is a mobile phone case with a backup battery and several solar panels for charging it. Also here, it is visually apparent that there are panels with several solar cells on one side of the cover but the type of solar cell is not specified.

The demands on solar panels for powering consumer products are quite different compared to stationary solar panels used for producing electricity in large solar parks. For example, the solar panel in a consumer product needs to be more robust, flexible, and able to resist impacts. Further, they must be able to produce power at various light conditions, both indoors and outdoors. The light conditions on different parts of the solar panel may also differ due to partial shading of the solar panel, which reduces the efficiency of the solar panel. It is also desired that the solar panels have an aesthetic appeal, since they are visible to the user.

It should be noted that there are many examples of photovoltaic chargers having a solar panel including a plurality of solar cells connected in series for powering portable electronic devices. However, there are several problems with the known solar panels powering the portable electronic devices: They are very sensitive to light intensity and the angle of the incoming light. A solar panel with solar cells connected in series is sensitive to partial shading because if one solar cell is not producing a current, the whole series of solar cells will stop producing electricity. They are quite sensitive and are easily broken. For example, crystalline silicon solar cells are brittle and may crack when used on a portable electronic device. Furthermore, users may not agree with the aesthetics where large parts of the product are covered by solar panels having a grid of visible current collectors on the upper side. Thus, there is a need to improve the photovoltaic chargers for use with portable electronic devices.

WO2013/149787 discloses a dye-sensitized solar cell module having a serial structure comprising a plurality of dye-sensitized solar cell units arranged adjacent to each other and connected in series. Each cell unit includes a working electrode, a first conducting layer for extracting photo-generated electrons from the working electrode, a counter electrode including a second conducting layer, electrolyte for transferring electrons from the counter electrode to the working electrode, and a series connecting element for electrically connecting the counter electrode to a working electrode of an adjacent cell unit. The solar cell module comprises a porous insulating substrate, the first conducting layer is a porous conducting layer formed on one side of the porous insulating substrate, and the second conducting layer is a porous conducting layer formed on the opposite side of the porous insulating substrate, and the series connecting element is a conducting layer penetrating through the porous insulating substrate and extending between the first conducting layer of one of the cell units and the second conducting layer of the adjacent cell unit, thereby electrically connecting the first conducting layer of one of the cell units with the second conducting layer of the adjacent cell unit.

### Summary

The aim of the present invention is to at least partly overcome the above problems, and to provide an improved photovoltaic charger adapted for charging electronic devices for consumer applications, and more particularly for charging rechargeable batteries of the electronic devices.

This aim is achieved by a photovoltaic charger as defined in claim 1.

The photovoltaic charger comprises a solar cell unit including a working electrode comprising a porous light-absorbing layer including dyed TiO₂, a porous first conducting layer for extracting photo-generated electrons from the light-absorbing layer, wherein the light-absorbing layer is arranged on top of the first conducting layer, a porous substrate made of an insulating material and extending through the entire solar cell unit, wherein the first conducting layer is formed on one side of the porous substrate, a counter electrode including a second conducting layer, wherein the second conducting layer is formed on the opposite side of the porous substrate, and a conducting medium for transferring charges between the counter electrode and the light-absorbing layer. The photovoltaic charger further comprises an encapsulation encapsulating the solar cell unit, a first conductor electrically connected to the first conducting layer, and a second conductor electrically connected to the second conducting layer. According to the invention, the photovoltaic charger contains only one single solar cell unit and a boost converter electrically connected to the first and second conductors, and the boost converter is adapted to step up the voltage from the solar cell unit while stepping down the current from the solar cell unit.

The invention is based on the realization that such type of solar cell unit has excellent properties, which makes it particularly suitable for charging electronic devices for consumer applications used indoors as well as outdoors. The invention is also based on the realization that having only one single solar cell unit in the photovoltaic charger provides further benefits and makes the photovoltaic charger even more suitable for charging electronic devices for consumer applications.

The photovoltaic charger according to the invention is capable of charging devices when the light conditions are very poor. For example, the photovoltaic charger is capable of charging the electronic devices when the only light source is a lamp. This makes it possible to charge electronic devices indoors at night.

Furthermore, since the photovoltaic charger has only one single solar cell unit, there will be no problems from partial shading. Even if parts of the surface of the solar cell unit are shaded, the non-shaded parts will still produce a current. Thus, the photovoltaic charger according to the invention is still capable of charging the electronic device even when the active area of the photovoltaic charger is partially shaded. With active area is meant the area of the solar cell unit, which contributes to produce power when it is exposed to light.

The first conductor works as a current collector and collects currents from the first conducting layer. The second conductor works as a current distributor and distributes currents to the second conducting layer. The photovoltaic charger has one single scalable solar cell which can be adapted to any shape or size of a portable electronic device. There is no need for a plurality of current collectors arranged across the visible side of the photovoltaic charger, and the absence of visible current collectors result in a visually homogenous surface. Thus, the photovoltaic charger can be used on the portable electronic device without affecting the design of the device. In other words, a portable electronic device can be powered by the photovoltaic charger without it being visible to the onlooker. Another advantage with not having many connection elements arranged over the surface of the solar cell unit is that more area of the solar cell unit can be used for generating power since there are not a plurality of current collectors blocking the incoming light.

Further advantages with the photovoltaic charger include low costs, impact resistance, flexibility, and independence of the angle of the incoming light. A porous light-absorbing layer including dyed TiO₂ is non-brittle and is not dependent on the angle of the incoming light. Further, the size of the single solar cell unit is scalable, and accordingly the size and power of the photovoltaic charger can be adapted to the size and power demand of different devices to be charged. By increasing the area of the solar cell unit, the power generated by the photovoltaic charger is increased.

The photovoltaic charger comprises a boost converter electrically connected to the first and second conductors and the boost converter is adapted to step up the voltage from the solar cell unit while stepping down the current from the solar cell unit. Thus, the photovoltaic charger is capable to generate a sufficient voltage level for charging electronic devices in a wide range of different light conditions. Different types of batteries require different voltage levels. The boost converter makes it possible to provide rechargeable batteries of electronic devices with the voltage level needed by the type of battery. The voltage produced by the single solar cell unit is too low to charge certain types or batteries, for example, lithium batteries that require about 3.6 V. In the prior art, the required voltage is achieved by arranging a plurality of solar cell units connected in series. According to the invention, the required voltage is achieved by connecting a boost converter to the single solar cell unit. Thus, it is possible to provide a photovoltaic charger having only one solar cell unit capable to charge batteries that require different voltage levels.

In one aspect, the boost converter is configured to convert the output voltage from the solar cell unit to a voltage that lies between 1 and 10 V. Thus, the photovoltaic charger is capable of charging batteries used for many types of electronic devices for consumer applications, such as lithium or nickel based batteries.

The conducting medium for transferring charges between the counter electrode and the light-absorbing layer can, for example, be a liquid, such as a liquid iodide/triiodide electrolyte, a liquid copper complex or a liquid cobalt complex based electrolyte, a gel, or a solid material such as a solid hole conductor.

According to one aspect, the conducting medium is an ionic based electrolyte. The electrolyte can be a liquid or a gel. An advantage with using an ionic based electrolyte is that it can render high long-term stability to the solar cell performance. Another advantage is that the efficiency of the photovoltaic charger is stable or increases with increasing temperature. Accordingly, the photovoltaic charger operates well in a wide range of temperatures.

According to one aspect of the invention, the solar cell unit produces more than 5 µW/cm² measured on active solar cell area, when the light intensity received by the light-absorbing layer is 200 Lux. It has been proven through tests that the photovoltaic charger according to the invention is capable of producing more than 5 µW/cm² when the light intensity received by the light-absorbing layer is 200 Lux. Lux is a suitable unit for measuring light intensity since it measures the intensity of light perceived by the human eyes. Lux is commonly used to measure the intensity of indoor light, which is mostly within the part of electromagnetic spectrum that is visible to the human eye. Accordingly, it is suitable to relate the efficiency of the solar cell unit to the light intensity measured in Lux.

According to one aspect of the invention, the solar cell unit produces more than 5.5 µW/cm² when the light intensity received by the light-absorbing layer is 200 Lux. It has been proven through tests that the photovoltaic charger according to the invention is capable to produce more than 5.5 µW/cm² when the light intensity received by the light-absorbing layer is 200 Lux.

According to one aspect of the invention, the solar cell unit produces at least 150 µW/cm² when the light intensity received by the light-absorbing layer is 5 000 Lux.

According to one aspect of the invention, the solar cell unit produces at least 600 µW/cm², and preferably at least 700 µW/cm² when the light intensity received by the light-absorbing layer is 20 000 Lux. More particularly, the solar cell unit is capable of producing at least between 5 and 600 µW/cm² when the light intensity received by the light-absorbing layer is between 200 and 20 000 Lux. The power produced by the photovoltaic charger increases substantially linearly when the light intensity received by the light-absorbing layer increases from 200 to 20 000 Lux. Thus, the photovoltaic charger is capable of producing power in a wide range of different light conditions. The photovoltaic charger works during poor as well as excellent lighting conditions, for example, indoors in artificial light, outdoors in the shadow and when exposed to strong sunlight.

With substantially linear is meant that the power produced increases linearly with increasing light intensity at least in a main part of the interval 200 and 20 000 Lux. For example, the power produced may differ slightly from linear with intensities between 200 and 1000 Lux.

According to one aspect of the invention, the solar cell unit generates a voltage varying less than 40 %, when the light intensity received by the light-absorbing layer varies between 200 and 50 000 Lux. For example, the solar cell unit generates a voltage varying less than 0.4 V, and preferably less than 0.3 V, when the light intensity received by the light-absorbing layer varies between 200 and 50 000 Lux. The voltage generated by the solar cell unit is quite even in the interval 200 to 50 000 Lux. This means that the produced voltage is fairly independent of the light intensity. Due to the fact that the voltage output from the solar cell unit only varies a little when the light intensity received by the light-absorbing layer varies between 200 and 50 000 Lux, it is possible to use a boost converter to step up the voltage for a wide range of different light intensities without extensive loss during the conversion.

According to one aspect of the invention, the electrolyte comprises ions, for example copper ions, or iodide and triiodide ions. The level of the generated voltage depends on the ions in the electrolyte. For example, if the electrolyte contains copper ions, the solar cell unit can generate a voltage of about 1 V in an open circuit when the light intensity received by the light-absorbing layer is 20 000 Lux, and if the electrolyte contains iodide and triiodide ions, the solar cell unit can generate a voltage of 0.65 V in an open circuit when the light intensity received by the light-absorbing layer is 20 000 Lux.

According to one aspect of the invention, the solar cell unit generates a voltage of at least 0.3 V in an open circuit when the light intensity received by the light-absorbing layer is 200 Lux.

Further, the solar cell unit generates a voltage less than 1.2 V in an open circuit when the light intensity received by the light-absorbing layer is 20 000 Lux.

According to one aspect of the invention, the boost converter is capable of converting a voltage between 0.25 and 1 V to a voltage above 3 V, and preferably above 3.5 V. Thus, the photovoltaic charger can be used to charge a battery having a load voltage above 3 V, such as a lithium battery that typically requires a load voltage between 3 and 4,5 V depending on how loaded the battery is.

According to one aspect of the invention, the current produced by the photovoltaic charger increases linearly when the light intensity received by the light-absorbing layer increases from 200 to 20 000 Lux.

According to one aspect of the invention, the solar cell unit produces a current of at least 15 µA/cm² when the light intensity received by the light-absorbing layer is 200 Lux, and the current produced by the solar cell unit is linearly increasing when the light intensity received by the light-absorbing layer increases from 200 to 20 000 Lux. Due to the linearity, and the fact that the solar cell unit does not produce any current when the light intensity is zero and produces a current of at least 15 µA/cm² when the light intensity is 200 Lux, the solar cell unit produces a current of about 1500 µA/cm² when the light intensity received by the light-absorbing layer is 20 000 Lux. Thus, the solar cell unit is capable of producing sufficient power to charge batteries of electronic devices in a wide range of light intensities.

According to one aspect of the invention, the first and second conducting layers comprise metal or a metal alloy. Metal and metal alloys are good conductors of electricity. Thus, having conducting layers made of metal or metal alloy leads to small resistive power losses during current collection and current distribution when high currents are generated in the solar cell unit.

According to one aspect of the invention, the first and second conducting layers comprises titanium or an alloy thereof. It is advantageous to use titanium since it is highly corrosion resistant and can resist high temperatures in air without oxidizing significantly, which is advantageous during production of the solar cell unit.

According to one aspect of the invention, the boost converter is capable to handle currents between 15 and 9000 mA/cm². Thus, the boost converter is capable to handle currents from the solar cell unit from 200 lux to 120 000 lux, which is full sun light.

According to one embodiment of the invention, the conducting medium comprises iodide (I⁻) and triiodide (I₃⁻) and the content of triiodide in the conducting medium is between 1 mM and 20 mM. This embodiment makes it possible to achieve high power generation at low light intensities.

According to one aspect, the first conducting layer and the porous substrate are continuously extending through the entire solar cell unit.

According to one aspect of the invention, the porous substrate is a sheet comprising woven microfibers extending through the entire solar cell unit. For example, the woven microfibers are made of glass fibres. The sheet comprising woven microfibers extending through the entire solar cell unit contributes to provide a flexible, twistable, and impact resistant photovoltaic charger.

According to one aspect, the solar cell unit has a top side facing the light and a bottom side, the first conductor is elongated and is disposed at any of the bottom side of the solar cell unit or extends along an edge of the top side of the solar cell unit, and the second conductor is elongated and disposed on the bottom side of the solar cell unit. If the first conductor is arranged along an edge of the top side of the solar cell unit or at the bottom side of the solar cell unit it is easy to hide, and will not be visible for the user.

According to one aspect, the solar cell unit has a top side facing the light and a bottom side, and the first and second conductors are elongated and disposed on the bottom side of the solar cell unit. Thus, the first and second conductors are not visible to the user, and the appearance of the top side of the solar cell unit is homogenous.

According to one aspect, the encapsulation comprises a plurality of penetrations in physical and electrical connection to the first and second conductors for connecting the photovoltaic device to the external device. In other words, there are penetrations in the encapsulation for accessing the power produced by the photovoltaic device. Some kind of wiring will be going through the penetrations. For example, the first and second conductors may extend out of the encapsulation through the penetrations to connect to wiring for powering the external device. Alternatively, wires from the outside of the encapsulation are going through the penetrations and electrically connect to the first and second conductors. The penetrations are tightly fit around the wiring passing through the encapsulation such that no gas or liquid can pass through penetrations. For example, the penetrations are openings in the encapsulation tightly fit around wiring passing through the encapsulation.

According to one aspect, the encapsulation comprises an at least partly transparent top sheet covering a top side of the solar cell unit and a bottom sheet covering a bottom side of the solar cell unit. With encapsulation is meant a cover sealing enclosing the solar cell unit to prevent dust and damp to enter the solar cell unit and to prevent electrolyte from the inside to leak out from the device. The purpose of the encapsulation is to maintain the integrity of the solar cell components and solar cell composition.

According to one aspect, the first conductor is disposed on the top side of the solar cell unit and extends along an edge of the top side of the solar cell unit. The first conductor can then be covered by, for example plastic, so that it is not visible to the onlooker. Since the first conductor is placed along the edge, it is easily covered without impacting the efficiency of the photovoltaic charger or its overall appearance.

According to one aspect, the first conductor and the second conductor are disposed on the bottom side of the solar cell unit. Thus, there will then be no visible wiring on the upper side of the photovoltaic charger. The first and second conductors can easily be hidden by disposing the photovoltaic charger on a surface of the device, or a cover of the device. This means that when the photovoltaic charger is placed on a surface of the device, the first conductor is not visible for a user. This makes it possible to integrate the photovoltaic charger in the device, or a cover of the device, so that a user will not even notice that there is a photovoltaic charger integrated in the device. Substantially a whole surface of the device can be covered by the photovoltaic charger. Thus, the whole surface of the device or cover of the device can be used to produce power without affecting the visible appearance of the device.

According to one aspect, the second conducting layer and the porous substrate are continuously extending through the entire solar cell unit.

According to one aspect, the first conducting layer is non-transparent and extends continuously through the entire solar cell unit. The light-absorbing layer extends continuously through the solar cell unit on top of the first conducting layer, except possibly for a minor area of the first conducting layer reserved for the first conductor.

According to one aspect, the appearance of the top side of the solar cell unit is homogenous. Due to the fact that the photovoltaic charger only contains one single solar cell unit, the light-absorbing layer extends continuously through the solar cell unit on top of the first conducting layer, and there are no visible conductors extending across the top surface of the solar cell unit, the surface of the top side of the solar cell unit becomes visually homogenous. This means that the appearance of the upper side of the photovoltaic charger is uniform, and not interrupted by any current collectors or has any change in color. This makes it possible to integrate the photovoltaic charger in electronic devices without impairing the visible appearance of the electronic device. The user may not even notice the photovoltaic charger.

According to one aspect, the top side of the solar cell unit is homogenously black. The TiO₂ of the light-absorbing layer is black and achieves a black surface of the solar cell unit. Due to the fact that the light-absorbing layer comprises TiO₂ and extends continuously through the solar cell unit on top of the first conducting layer, the top surface of the solar cell unit becomes homogenously black. The top sheet covering the top side of the solar cell unit is preferably arranged so that it will not affect the appearance of the top surface. The top sheet is transparent or at least the part covering the active area of the solar cell unit is transparent. Thus, the upper surface of the photovoltaic charger is also homogenously black. An advantage with a homogenously black light absorbing active surface is that it has maximum light-absorbing properties. Another advantage is that a homogenously black surface is aesthetically attractive.

According to one aspect, the encapsulation is made of a transparent plastic. This feature contributes to provide a flexible, twistable, and impact resistant photovoltaic charger.

According to some aspects, the shape and size of the single solar cell unit is adapted to the size and shape of the portable electronic device it is powering. Further, the active area of the solar cell unit is adapted to the power needed to charge the device.

According to one aspect, the shortest distance from side to side of the active area of the solar cell unit is larger than 1 cm, and preferably larger than 1.5 cm.

According to one aspect, the shortest distance from side to side of the active area of the solar cell unit is larger than 1.5, and the active area of the solar cell unit is larger than 25 cm², Such a photovoltaic charger is, for example, useful for charging head phones.

According to one aspect, the shortest distance from side to side of the active area of the solar cell is larger than 10 cm. Thus, the active area of the solar cell unit is larger than 100 cm². Such a photovoltaic charger is, for example, useful for charging a tablet.

According to an aspect, the portable electronic device is any of head phones, a tablet, or a mobile phone.

According to another aspect of the invention, it comprises use of the photovoltaic charger according to above for powering a portable electronic device. For example, the portable electronic device is head phones, a mobile phone, or a tablet.

According to some aspects, the portable electronic device is head phones comprising a headband for reaching over a wearer's head, wherein the photovoltaic charger is arranged on a top surface of the headband.

According to some aspects, the portable electronic device is a tablet, wherein the photovoltaic charger is integrated in the tablet, or a casing of the tablet.

According to some aspects, the portable electronic device is a mobile phone, wherein the photovoltaic charger is integrated in the mobile phone or in a casing of the mobile phone.

According to another aspect of the invention, it comprises a method for producing a photovoltaic charger for powering a portable electronic device.

The method comprises:
- producing a sheet with the single solar cell unit,
- adapting the shape and size of the single solar cell unit to a surface on which to place the single solar cell unit by cutting a piece of the sheet with the single solar cell unit into said shape and size,
- arranging the first conductor in electrical contact with the first conducting layer,
- arranging the second conductor in electrical contact with the second conducting layer,
- arranging a top sheet and a bottom sheet of the encapsulation so they enclose said piece of sheet and at least partly enclose the first and second conductors, such that the shape and size of the encapsulation is adapted to the shape and size of the single solar cell unit, and
- sealing the edges of the top sheet and the bottom sheet to form the encapsulation.

The method for manufacturing the photovoltaic charger is simple and cost efficient.

According to an aspect, the method comprising arranging first and second conductors between the solar cell unit and the encapsulation on the bottom side of the single solar cell unit.

According to an aspect, the method comprises arranging the first conductor along at least a part of an edge of the top side, and arranging the at least one second conductor on the bottom side of the single solar cell unit.

### Brief description of the drawings

The invention will now be explained more closely by the description of different embodiments of the invention and with reference to the appended figures.
Fig. 1 shows a view from above of a photovoltaic charger in accordance with one or more embodiments of the invention.
Fig. 2 shows a cross section through the photovoltaic charger shown in figure 1 in an enlarged view.
Fig. 3 shows a view from above of a part of a photovoltaic charger in accordance with one or more embodiments of the invention.
Fig. 4 shows a view from below of the part of the photovoltaic charger shown in figure 3.
Fig. 5 shows a cross section through the part of the photovoltaic charger shown in figure 3.
Fig. 6 shows a cross section through a part of a photovoltaic charger in accordance with one or more embodiments of the invention.
Fig. 7 shows a diagram of measured values for generated voltage (mV) for light intensities between 200 and 20 000 Lux for a first example of a solar cell unit having an electrolyte comprising iodide and triiodide ions.
Fig. 8 shows a diagram based on measured values for generated current (µA/cm²) for light intensities between 200 and 20 000 Lux for the first example of the solar cell unit.
Fig. 9 shows a diagram based on measured values for generated power per area (µW/cm²) for light intensities between 200 and 20 000 Lux for the first example of the solar cell unit.
Fig. 10 shows a diagram of measured values for generated voltage (mV) for light intensities between 200 and 50 000 Lux for a second example of a solar cell unit having an electrolyte comprising copper ions.
Fig. 11 shows a diagram based on measured values for generated current (µA/cm²) for light intensities between 200 and 50 000 Lux for the second example of the solar cell unit.
Fig. 12 shows a diagram based on measured values for generated power per area (µW/cm²) for light intensities between 200 and 50 000 Lux for the second example of solar cell unit.
Fig. 13 shows an example of a tablet having a photovoltaic charger for charging the tablet integrated in a cover.
Fig. 14 shows a view from above of an example of head phones having a photovoltaic charger integrated in a headband of the head phones.
Figs. 15a-b show side views of the head phones shown in figure 14.
Fig. 16 shows a flow diagram of a method for producing the photovoltaic charger.

### Detailed description

Aspects of the present disclosure will be described more fully hereinafter with reference to the accompanying drawings. The photovoltaic charger and the method disclosed herein can, however, be realized in many different forms and should not be construed as being limited to the aspects set forth herein. Like numbers in the drawings refer to like elements throughout.

The terminology used herein is for the purpose of describing particular aspects of the disclosure only, and is not intended to limit the invention.

Unless otherwise defined, all terms used herein have the same meaning as commonly understood by one of ordinary skill in the art to which this disclosure belongs.

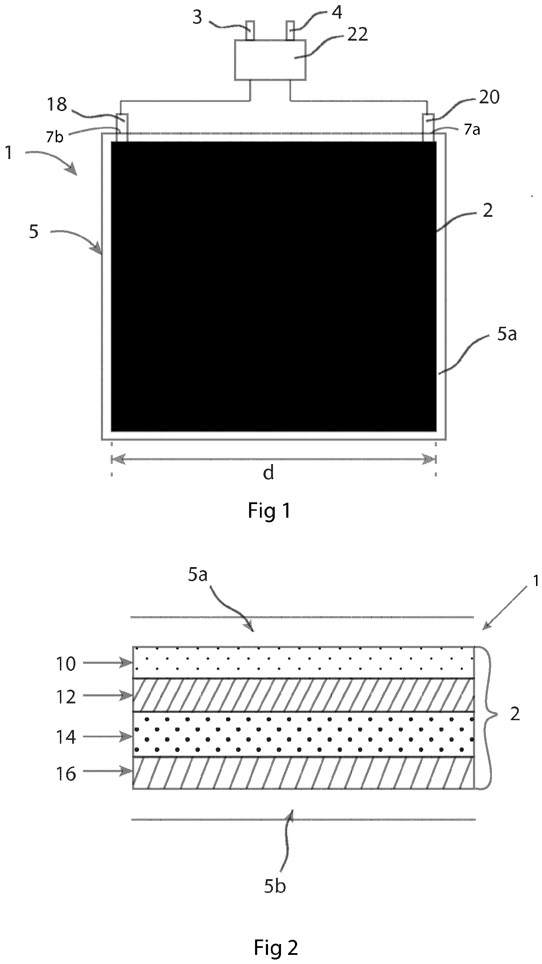

Figure 1 shows a view from above of a photovoltaic charger 1 according to an embodiment of the invention. The photovoltaic charger 1 is specially adapted for powering portable electronic devices that can be used indoors as well as outdoors, such as earphones, laptops, tablets, mobile phones, and remote-control units. The photovoltaic charger 1 can also be used for powering small electronic devices embedded in other physical devices, such as vehicles, and home appliances, called Internet of Things (loT).

The photovoltaic charger 1 comprises a solar cell unit 2, an encapsulation 5 enclosing the solar cell unit 2, a first conductor 18, and a second conductor 20. The photovoltaic charger may further comprise connection elements (not shown) for connecting the photovoltaic charger 1 to the electronic device. The solar cell unit is a dye-sensitized solar cell (DSC). Preferably, the solar cell unit is a monolithic type DSC. The monolithic type of DSC differs from the standard DSC in that it is created on a single substrate, with multiple layer disposed on the substrate. The encapsulation comprises a plurality of penetrations in connection to the first and second conductors for connecting the photovoltaic device to the external device. In other words, there are penetrations in the encapsulation for accessing the power produced by the photovoltaic device. Some kind of wiring will be going through the penetrations. For example, the first and second conductors may extend out of the encapsulation through the penetrations to connect to wiring for powering the external device. Alternatively, wires from the outside of the encapsulation are going through the penetrations and electrically connect to the first and second conductors. The penetrations are tightly fit around the wiring passing through the encapsulation such that no gas or liquid can pass through penetrations. For example, the penetrations are openings in the encapsulation tightly fit around wiring passing through the encapsulation.

The encapsulation 5 comprises a plurality of penetrations 7a- b arranged in connection to the first conductor 18 and the second conductor 20 for connecting the photovoltaic device 1 to the external device and by that access the power produced by the photovoltaic device. For example, the penetrations are lead trough openings in the encapsulation. Some kind of wiring will be going through the openings. For example, the first and second conductors 18, 20 may extend out of the encapsulation through the penetrations 7a-b to connect to wiring for powering the external device, as shown in figure 1. Alternatively, wires from the outside of the encapsulation are going through the penetrations and electrically connected to the first and second conductors. The penetrations are tightly fit around the wiring such that no gas or liquid can pass through them. The penetrations can be made by having the wires or conductors that should go through the holes in place when the encapsulation is arranged on the solar cell unit 2. The top sheet 5a and bottom sheet 5b are, for example, adhesive films that are put together over the solar cell unit 2. Alternatively, the top and bottom sheets are made of a flexible plastic material, and the edges of the top and bottom sheets are bonded to each other by melting the plastic material. If the wires/conductors are already in place between sheets before the bonding and protrude at the edges of the sheets, the penetrations will be created during the bonding. Alternatively, the penetrations comprise through holes in the encapsulation made after encapsulation of the solar cell unit. The trough holes are sealed after the wires/conductors have been arranged in the through holes. The locations of the penetrations will depend on the position of the first and second conductors. The number of penetrations can vary. There is at least one penetration for each of the first and second conductor. However, it is also possible to have a plurality of penetrations for each of the first and second conductors.

Figure 2 shows an enlargement of a cross section through a part of the photovoltaic charger 1 shown in figure 1. The solar cell unit 2 comprises a working electrode including a porous light-absorbing layer 10, a porous first conducting layer 12 for extracting photo-generated electrons from the light-absorbing layer 10. The light-absorbing layer 10 comprises dyed TiO₂. Conventional dyes known in the art can be used. A dye is chosen to give good efficiency of the solar cell, especially in combination with a copper-based conducting medium. The light-absorbing layer may also comprise silicon, Si, grains or grains of CdTe, CIGS, CIS, GaAs, perovskite can also be applicable.

The light-absorbing layer 10 is arranged on top of the first conducting layer 12. The solar cell unit 2 further comprises a porous substrate 14 made of an insulating material, and a counter electrode including a second conducting layer 16. In this example, the second conducting layer is porous. However, in an alternative embodiment, the second conducting layer does not have to be porous. For example, the second conducting layer can be made of a metal foil. The first conducting layer 12 is formed on one side of the porous substrate 14 and the second conducting layer 16 is formed on the opposite side of the porous substrate 14. The first conducting layer 12 is in direct electrical contact with the light-absorbing layer 10. The porous substrate 14 provides electrical insulation between the first and second conducting layers 12, 16. The first and second conducting layers 12, 16 are separated physically and electrically by the porous substrate 14. The porosity of the porous substrate 14 will enable ionic transport through the substrate. For example, the thickness of the porous insulating substrate 14 is larger than 4 µm and less than 100 µm. The porosity of the first and second conducting layers 12, 16 will enable ionic transport through the conducting layers.

The porous light-absorbing layer 10 is a porous TiO₂ layer deposited onto the first conducting layer 12. The TiO₂ layer comprises TiO₂ particles dyed by adsorbing dye molecules on the surface of the TiO₂ particles. The light-absorbing layer 10 is positioned on a top side of the solar cell unit 2. The top side should be facing the light to allow the light to hit the dye molecules of the working electrode.

The photovoltaic charger 1 contains only one single solar cell unit 2. At least the first conducting layer 12 and the porous substrate 14 are continuously extending through the entire solar cell unit. The light-absorbing layer 10 and the second conducting layer 16 extend continuously at least through a main part of solar cell unit. In one alternative example, a minor part of the light-absorbing layer 10 can be removed along an edge of the solar cell unit to allow a first conductor 18 on a top side of the solar cell unit to have electrical contact with the first conducting layer 12. In another alternative example, a minor part of the second conducting layer 16 can be removed to allow the first conductor 18 to have electrical contact with the first conducting layer 12 from a bottom side of the solar cell unit. In this example, thee solar cell unit is filled with an electrolyte for transferring charges between the counter electrode and the light-absorbing layer 10. The electrolyte is, for example, a conventional I⁻/I⁻³ electrolyte or a similar electrolyte, or a copper (Cu) based electrolyte, or cobalt (Co) complex based electrolyte. The electrolyte comprises ions, for example, iodide ions (I⁻) and triodide ions (I₃⁻) or copper ions (Cu²⁺ and Cu⁺). Sunlight is harvested by the dye, producing photo-excited electrons that are injected into the conduction band of the TiO₂ particles and further collected by the first conducting layer. At the same time, ions in the electrolyte transport the electrons from the second conducting layer to the light-absorbing layer 10. The first conductor 18 collects the electrons from the first conducting layer and the second conductor provides electrons to the second conducting layer such that the solar cell unit can continuously produce power from the incoming photons.

The electrolyte penetrates the pores of the light-absorbing layer 10, the first conducting layer 12, the porous substrate 14, and the second conducting layer 16 to allow the ions to be transferred between the light-absorbing layer 10 and the second conducting layer 16 and by that transfer electrons from the second conducting layer to the light-absorbing layer.

There are many dyes that may be used and according to some aspects, the dye comprises triarylamine organic dye comprising any of, or a mixture of, dyes in the class Donor-π bridge-Acceptor (D-π-A) and in the class Donor-Acceptor-π bridge-Acceptor (D-A-π-A). Such dyes give good efficiency of the solar cell, especially in combination with a copper-based conducting medium. Of the first-class photosensitizer are, for example, substituted (diphenylaminophenyl)-thiophene-2-cyanoacrylic acids or substituted (diphenylaminophenyl)cyclopenta-dithiophene-2-cyanoacrylic acids. Of the second class are, for example, substituted (((diphenylaminophenyl)benzothia-diazolyl)-cyclopentadithiophenyl)aryl/heteroaryl-2-cyanoacrylic acids or (((diphenyl-aminophenyl)-cyclopentadithiophenyl)benzothiadiazolyl)aryl/heteroaryl-2-cyano-acrylic acids.

The first conductor 18 is electrically connected to the first conducting layer 12, and the second conductor 20 is electrically connected to the second conducting layer 16. For example, the first and second conductors are made of metal to achieve high electrical conductivity.

The encapsulation 5 comprises a top sheet 5a covering a top side of the solar cell unit 1, and a bottom sheet 5b covering a bottom side of the solar cell unit. The encapsulation 5 encloses the solar cell unit and the electrolyte, and acts as liquid barrier for the electrolyte and prevents the electrolyte from leaking from the photovoltaic charger 1. The top sheet 5a is transparent, or at least the part covering the active area of the solar cell unit 2 is transparent. The top sheet 5a on the top side of the solar cell unit covers the light-absorbing layer 10 and allows light to pass through. The top and bottom sheets 5a-b are, for example, made of a polymer material. A polymer material is robust and impact resistant, and flexible. The top and bottom sheets 5a-b are sealed at the edges in order to protect the solar cell unit against the surrounding atmosphere, and to prevent the evaporation or leakage of the electrolyte from the inside the solar cell unit.

The counter electrode may comprise a catalytic layer. Alternatively, the second conducting layer 16 may comprise catalytic particles integrated in the second conducting layer.

For example, the first and second conducting layers 12, 16 are made of a material selected from a group consisting of titanium, titanium alloys, nickel alloys, graphite, and amorphous carbon, or mixtures thereof. Preferably, the first and second conducting layers 12, 16 are made of metal or a metal alloy to provide high electrical conductivity. Most preferably, the porous conducting layers are made of titanium or a titanium alloy. In this example, the first and second porous conducting layers 12, 16 are made of titanium (Tᵢ).

In one example, the porous substrate is a sheet comprising a fabric of woven microfibers. A microfiber is a fibre having a diameter less than 10 µm and larger than 1 nm. A fabric of woven microfibers can be made very thin and mechanically very strong. The fabric of woven microfibers contains holes between the woven yarns. The porous substrate may further comprise one or more layers of non-woven microfibers disposed on the woven microfibers to at least partly block the holes between the yarns. Further, the non-woven layer provides a smooth surface on the substrate, suitable for applying a smooth conducting layer on the substrate by printing. The substrate is, for example, made glass, silica (SiO₂), alumina (Al₂O₃), aluminosilicate or quartz. Suitably, the non-woven and woven microfibers of the porous substrate are made of glass fibres, which provides a robust and flexible substrate. The thickness of the fabric of woven microfibers is suitably between 4 µm and 30 µm, preferably between 4 µm and 20 µm to provide the required mechanical strength at the same time as it is thin enough to enable a fast transport of ions between the counter electrode and working electrode.

In one aspect, light-absorbing layer 10, and the first conducting layer 12 are non-transparent. In this example, the upper surface of the solar cell unit 2 is homogeneously black, as shown in figure 1. The TiO₂ of the light-absorbing layer is black. There are no conductors extending across the surface of the solar cell unit 2 as it is in the prior art solar cell panels. This is because the photovoltaic charger 1 only contains one single solar cell unit, and not a plurality of series connected solar cell units, as in the solar panels used in the prior art photovoltaic chargers.

The size of the solar cell unit, i.e. the length and width of the solar cell unit, may vary depending on which device it is adapted to charge. Accordingly, the active area of the solar cell unit may vary depending on the need of power for the device to charge. There is no limit to the possible shape and size of the solar cell unit. For example, the size of the solar cell unit may vary between 1x1 cm with an active area of 1 cm² and 1x1 m with an active area of 1 m². There is no upper limit to the length and width of the solar cell unit. However, a solar cell unit larger than 1x1 m can be bulky to handle during manufacturing of the solar cell unit.

The photovoltaic charger 1 includes a single solar cell unit 2 and a boost converter 22 electrically connected to the first and second conductors 18, 20. A boost converter, also called step-up converter or step-up regulator, is a DC-to-DC power converter that steps up voltage while stepping down current from its input to its output. The voltage produced by the single solar cell unit is too low to charge certain types or batteries, for example, lithium batteries that require at least 3.6 V. The boost converter is adapted to step up the voltage from the solar cell unit 2 while stepping down the current from the solar cell unit. The required voltage level is achieved by connecting a boost converterto the single solar cell unit. Thus, it is possible to provide a photovoltaic charger having only one single solar cell unit capable to charge batteries that require different voltage levels.

The photovoltaic charger 11 comprises connection elements 3, 4 for connecting the photovoltaic charger 1 to a battery of the electronic device, which it is charging. The boost converter 22 comprises input terminals electrically connected to the first and second conductors 18, 20 and output terminals electrically connected to the connection elements 3, 4.

The level of the generated voltage depends on the ions in the electrolyte. For example, if the electrolyte contains copper ions, the solar cell unit generates a voltage of about 1 V in an open circuit when the light intensity received by the light-absorbing layer is 20 000 Lux, and if the electrolyte contains iodide and triiodide ions, the solar cell unit generates a voltage of about 0.65 V in an open circuit when the light intensity received by the light-absorbing layer is 20 000 Lux. However, the solar cell unit 2 generates a voltage varying at most 0.4 V in an open circuit when the light intensity received by the light-absorbing layer is varying between 200 and 20 000 Lux. The requirement on the voltage conversion of the boost converter depends on the voltage requirement of the rechargeable battery. Most types of rechargeable batteries used for electronic devices for consumer applications require a voltage between 1 and 10 V. The boost converter makes it possible to generate a stable voltage at a level required by the rechargeable battery. Preferably, the boost converter 22 is capable to convert the output voltage and current from the solar cell unit to a voltage level that lies between 1 and 10 V. Different boost converters can be used depending on the required output voltage. Thus, the photovoltaic charger is capable to charge batteries used for many types of electronic devices, such as lithium batteries (3.6V), NiCd and NiMH batteries (1.25 V).

From tests it has been shown that the solar cell unit is capable to produce a current of at least 15 µA/cm² when the light intensity received by the light-absorbing layer is 200 Lux, and a current of at least 1500 µA/cm² when the light intensity received by the light-absorbing layer is 20 000 Lux. Thus, the solar cell unit is capable to produce sufficient power to charge batteries of electronic devices in a wide range of light intensities.

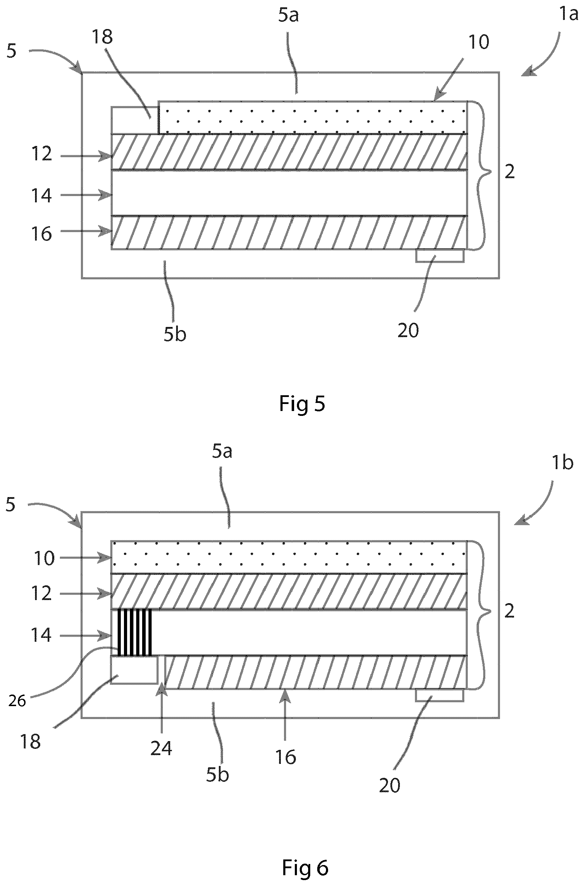

According to some aspects, at least the first conducting layer 12 and the porous substrate 14 are continuously extending through the entire solar cell unit 2. The light-absorbing layer 10 and the second conducting layer 16 extend continuously at least through a main part of the solar cell unit. In one example, as shown in figure 5, a minor part of the light-absorbing layer 3 can be removed so that the first conductor 18 on a top side of the solar cell unit 2 has direct electrical contact with the first conducting layer. In this example, the top side of the solar cell unit 2 is the top side of the light-absorbing layer 12 and the top side of the first conducting layer 12 where the light-absorbing layer has been removed. In another example, as shown in figure 6, one or more minor parts of the second conducting layer 16 can be removed so that the first conductor 18 can have electrical contact with the first conducting layer 12 from a bottom side of the solar cell unit 2.

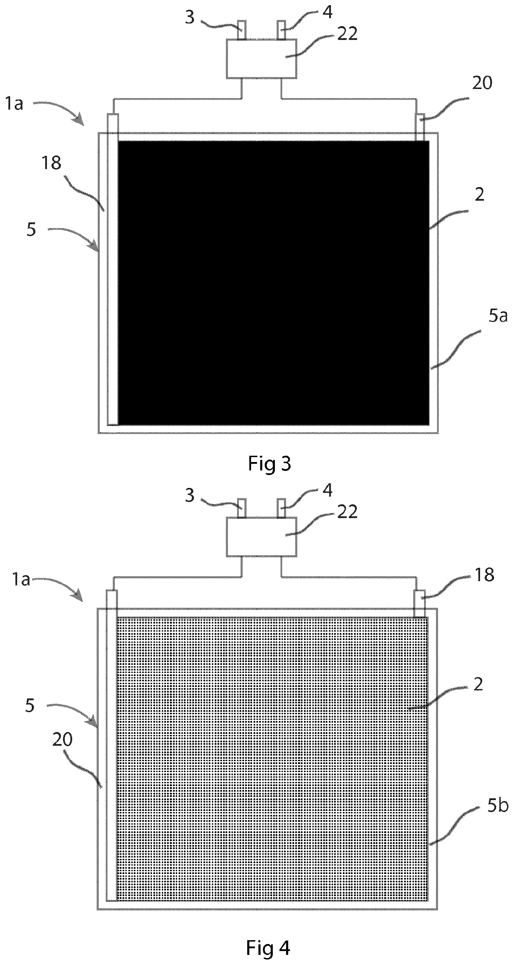

Figures 3 - 5 show a first example of how to arrange the first and second conductors 18, 20 on the solar cell unit 2. Figure 3 shows a view from above of a photovoltaic charger 1a. Figure 4 shows a view from below of the photovoltaic charger 1a, and figure 5 shows a cross section through the photovoltaic charger 1a. The photovoltaic charger 1a may comprise a boost converter 22 (not shown) electrically connected to the first and second conductors 18, 20 adapted to step up the voltage from the solar cell unit 2, as shown in figure 1. In this example, the first conductor 18 is electrically connected to the first conducting layer 12 and extending along an edge of the top side of the solar cell unit 2, as shown in figure 3. The second conductor 20 is electrically connected to the second conducting layer 16 and is disposed on the bottom side of the solar cell unit, as shown in figure 4. For example, the first and second conductors 18, 20 comprise a conducting foil or a wire. The first conductor 18 is disposed on the first conducting layer 12 and extends along an edge of the first conducting layer. Thus, the first conductor 18 does not disturb the design of the photovoltaic charger, or the device it is charging, and can easily be covered. An upper surface of first conducting layer 12 comprises an elongated surface portion facing the top sheet 5a, and the first conductor 18 is disposed on the elongated surface portion. The first conductor 18 is in mechanical and electrical contact with the first conducting layer, and extends along the elongated surface portion. The light-absorbing layer 10 ends close to the first conductor 18 and does not cover the elongated part of the first conducting layer 12 where the first conductor 18 is disposed.

The second conducting layer 16 has a bottom surface facing the bottom sheet 5b. The second conductor is in mechanical and electrical contact with the bottom surface, and the second conductor extends along the bottom surface. In this example, the photovoltaic charger has only one second conductor 20. Alternatively, the photovoltaic charger can have a plurality of second conductors extending across the bottom surface of the second conducting layer 16. In this example, the second conductor 20 extends along an edge of the bottom side of the solar cell unit 2, as shown in figure 4. However, the second conductor 20 can be arranged in many different ways as long as it is in electrical contact with the second conducting layer, since the second conductor 20 is not visible from the outside of the photovoltaic charger 1a.

The first conductor 18 is elongated and extends between the top sheet 5a of the encapsulation 5 and the first conducting layer 12 at the top side of the solar cell unit. The second conductor 20 is elongated and extends between the bottom sheet 5b of the encapsulation 5 and the second conducting layer 16 at the bottom side of the solar cell unit. The encapsulation is provided with a plurality of entries in connection to ends of the first and second conductors 18, 20 to allow the photovoltaic charger to be electrically connected to the external device it will power. The ends of the first and second conductors 18, 20 extend through the entries in the encapsulation to the outside of the photovoltaic charger. Suitably, the entries are arranged between the top and bottom sheets of the encapsulation. The conductors 18, 20 extend between the top and bottom sheets close to the ends of the photovoltaic charger, and the sheets are sealed around the conductors. This will facilitate manufacturing of the photovoltaic charger.

Figure 6 shows a second example of how to arrange the first and second conductors 18, 20 on the solar cell unit 2. Figure 6 shows a cross section through a photovoltaic charger 1b. This example differs from the previous example in that the first conductor 18 as well as the second conductor 20 are disposed at the bottom side of the solar cell unit 2. Thus, there is no visible conductors on a front side of the photovoltaic charger 1b. The first conductor 18 is arranged between the porous substrate 14 and the bottom sheet 5b. The first conductor 18 is electrically insulated from the second conducting layer 16. For example, the second conducting layer 16 ends at a distance from the first conductor 18 so that an insulating gap 24 is formed between the first conductor 18 and the second conducting layer 16. In this example, the first conductor 18 extends along an edge of the porous substrate. However, the first conductor 18 can be disposed on the porous substrate 14 in different ways. The first conductor 18 is in electrical contact with the first conducting layer 12. This can be achieved in different ways. For example, the porous substrate comprises conducting material disposed between the first conductor and the first conducting layer to achieve electrical contact between the first conductor 18 and the first conducting layer 12. For instance, a part of the porous substrate may comprise one or more through holes 26 filled with a conducting material, for example conducting particles, or the part may comprise conducting particles accommodated in pores of the porous substrate and forming a conducting path through the porous substrate. This can be achieved by infiltrating the porous substrate with conducting particles between the first conductor and the first conducting layer. The photovoltaic charger 1b may comprise a boost converter 22 (not shown) electrically connected to the first and second conductors 18, 20 and adapted to step up the voltage from the solar cell unit 2, as shown in figure 1.

Measurements of generated power per area for different light conditions have been made on an example of a photovoltaic charger of the invention. In this example, the solar cell unit has a size of 14.5 x 23.4 cm, and an active area of 340 cm². The electrolyte of the solar cell unit comprises iodide and triiodide ions, and the first and second conducting layers are made of titanium (Ti). The unloaded photovoltaic charger is exposed with light between 200 and 20 000 Lux (lumen per square meter), and the output voltage and output current from the photovoltaic charger is measured. The results of the measurements are shown in table 1 below. The total power generated is determined based on the measured current and voltage, and the generated power per area is determined by dividing the total power with the active area of the solar cell unit.

**Table 1 Measurements of generated power per active area, current per active area, voltage and fill factors (ff) for light intensities between 200 - 20 000 Lux for a solar cell unit having an electrolyte comprising iodide (I⁻) and triiodide (I₃⁻) ions. The content of triiodide is between 1 mM and 20 mM. Iodide works as ox and triiodide works as red.**

| Lux | µW/cm2 | I sc (µA/cm2) | Voc (mV) | ff (%) |
|---|---|---|---|---|
| 200 | 6,2 | 18 | 483 | 72 |
| 500 | 18 | 44 | 521 | 77 |
| 1000 | 37 | 90 | 542 | 76 |
| 2000 | 80 | 179 | 565 | 79 |
| 3000 | 123 | 266 | 576 | 80 |
| 5000 | 208 | 445 | 591 | 79 |
| 6000 | 249 | 531 | 600 | 78 |
| 10000 | 405 | 880 | 614 | 75 |
| 20000 | 730 | 1700 | 650 | 69 |

The measurements of the performance of the solar cell unit at different light intensities (intensities measured in Lux units) can be done by shining light on the solar cell unit, and simultaneously scanning an applied electrical voltage across the solar cell unit to measure and collect the current-voltage response of the solar cell. The measurements were performed using a warm - white LED as light source.

The collected IV curve under illumination provides information about the open circuit voltage, short circuit current, fill factor, the power and the power conversion efficiency. By collecting IV curves at different light intensities, it is possible to gather information on the light intensity dependence of the open circuit voltage, short circuit current, fill factor the power and the power conversion efficiency, respectively.

The result from table 1 is from measurements on a sample of a solar cell unit. Measurements on different solar cell units of this type may vary. For example, the generated power per area may from 5 µW/cm² to 8 µW/cm².

The light source used for shining light on the solar cell can vary depending on the solar cell application. For indoor applications it could be useful to use fluorescent light bulbs or indoor LED lighting. For solar cell applications that use outdoor light it could be useful to shine light on the solar cell using a solar simulator to generate artificial sunlight.

The light intensity of the light source can be measured in different ways, for example, using a lux meter or a spectroradiometer positioned at the same position as the solar cell unit in relation to the light source. In this case, the light intensity was measured using a lux meter.

Table 1 shows the determined power in microwatt per square centimetre (µW/cm²) for different light intensities measured in lux. As seen from the table, the solar cell unit generates 6.2 µW/cm² when the light intensity received by the solar cell unit is 200 Lux, generates 208 µW/cm² when the light intensity received by the solar cell unit is 5000 Lux, and generates 730 µW/cm² when the light intensity received by the solar cell unit is 20 000 Lux. This shows that the photovoltaic charger is capable of producing more than 5 µW/cm², and even more than 5.5 µW/cm² when the light intensity received by the light-absorbing layer is 200 Lux. This also shows that the photovoltaic charger is capable of producing more than 700 µW/cm² when the light intensity received by the light-absorbing layer is 20 000 Lux. Thus, the solar cell unit is at least capable of producing between 5,5 and 700 µW/cm² when the light intensity received by the light-absorbing layer is between 200 and 20 000 Lux. The power produced by the photovoltaic charger increases substantially linear when the light intensity received by the light-absorbing layer increases from 200 to 20 000 Lux. Thus, the photovoltaic charger is capable of producing power in a wide range of different light conditions.

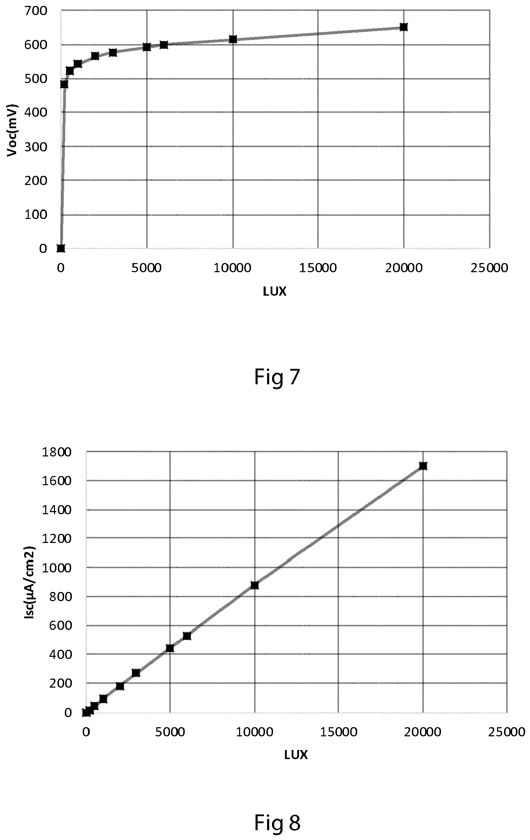

Figure 7 shows a diagram of generated voltage (mV) for light intensities between 200 and 20 000 Lux based on the measured values of table 1. As seen from the diagram and table 1, the solar cell unit is capable to generate a voltage of 480 mV in an open circuit when the light intensity received by the solar cell unit is 200 Lux. Further, the photovoltaic charger is capable to generate a voltage of 650 mV in an open circuit when the light intensity received by the solar cell unit is 20 000 Lux. As seen from the diagram, the increase of generated voltage is largest between 200 and 3000 Lux. The generated voltage is substantially linear between 3000 and 20 000 Lux. As seen from the table 1, the difference in generated voltage between 200 and 20 000 Lux is only 167 mV. Thus, the solar cell unit generates a voltage varying less than 0.2 V in an open circuit when the light intensity received by the light-absorbing layer is varying between 200 and 20 000 Lux. Accordingly, the difference in generated voltage between 200 and 20 000 Lux is about 35%.

Figure 8 shows a diagram of generated current (µA/cm²) for light intensities between 200 and 20 000 Lux based on the measured values of table 1. As seen from the figure, the current increase linearly.

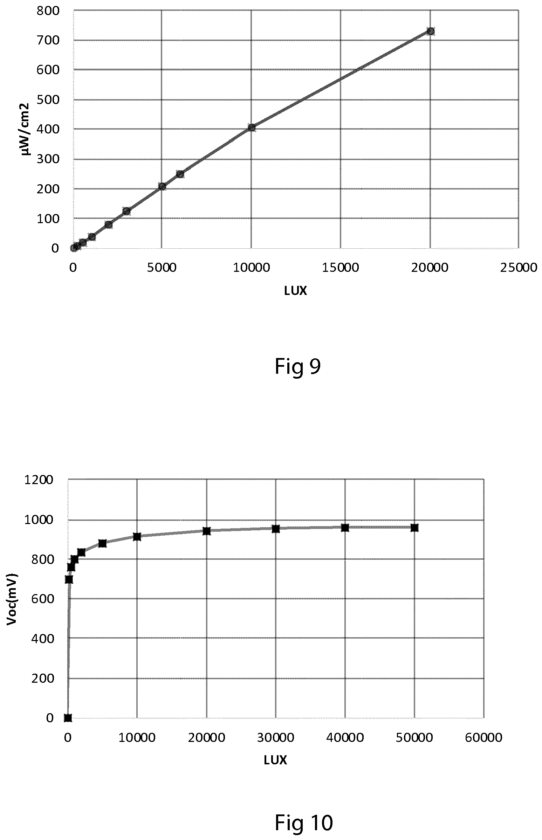

Figure 9 shows a diagram of generated power per area (µW/cm²) for light intensities between 200 and 20 000 Lux calculated based on the measured values of voltage and current of table 1. As seen from the diagram, the measured power is substantially proportional to the incoming light intensity in the interval 200 - 20 000 Lux.

Further measurements of generated power per area for different light conditions have been made on another example of a photovoltaic charger of the invention. In this example, the electrolyte of the solar cell unit comprises copper ions (Cu⁺ and Cu²⁺), which is the only difference between the photovoltaic chargers measured. The measurement conditions were the same. The unloaded photovoltaic charger is exposed with light between 200 and 20 000 Lux (lumen per square meter), and the output voltage and output current from the photovoltaic charger is measured. The result of the measurements is shown in the table 2 below.

**Table 2 Measurements of generated power per area, current per area, voltage and fill factor (ff) for light intensities between 200 - 20 000 Lux for a solar cell unit having an electrolyte comprising copper ions; Cu⁺as red and Cu²⁺as ox.**

| Lux | µW/cm2 | I sc (µA/cm2) | Voc (mV) | ff (%) |
|---|---|---|---|---|
| 0 | 0 | 0 | 0 | 0 |
| 200 | 12,8 | 25 | 699 | 72,7 |
| 500 | 38 | 67 | 762 | 74, 3 |
| 1000 | 85,4 | 140 | 800 | 76,1 |
| 2000 | 196 | 290 | 835 | 77,1 |
| 5000 | 498 | 737 | 881 | 76,6 |
| 10000 | 1020 | 1490 | 915 | 75,1 |
| 20000 | 2020 | 2960 | 943 | 72,3 |
| 30000 | 2920 | 4390 | 954 | 69,7 |
| 40000 | 3720 | 5750 | 958 | 67,6 |
| 50000 | 4410 | 7000 | 958 | 65,8 |

As seen from the table 2, the solar cell unit generates 12.8 µW/cm² when the light intensity received by the solar cell unit is 200 Lux, generates 498 µW/cm² when the light intensity received by the solar cell unit is 5000 Lux,and generates 2020 µW/cm² when the light intensity received by the solar cell unit is 20 000 Lux. This shows that this photovoltaic charger is capable of producing more than 12 µW/cm² when the light intensity received by the light-absorbing layer is 200 Lux. This also shows that the photovoltaic charger is capable of producing more than 2000 µW/cm² when the light intensity received by the light-absorbing layer is 20 000 Lux. The power produced by the photovoltaic charger increases substantially linear when the light intensity received by the light-absorbing layer increases from 200 to 20 000 Lux. Thus, the photovoltaic charger is capable of producing power in a wide range of different light conditions.

Figure 10 shows a diagram of generated voltage (mV) for light intensities between 200 and 50 000 Lux based on the measured values of table 2. As seen from the diagram and table 2, the solar cell unit is capable of generating a voltage of 699 mV in an open circuit when the light intensity received by the solar cell unit is 200 Lux. Further, the photovoltaic charger is capable to generate a voltage of 943 mV in an open circuit when the light intensity received by the solar cell unit is 20 000 Lux. As seen from the diagram, the generated voltage is substantially linear between 3000 and 50 000 Lux. As seen from the table 2, the difference in generated voltage between 200 and 20 000 Lux is only 244 mV. Accordingly, the difference in generated voltage between 200 and 20 000 Lux is about 35%. The difference in generated voltage between 200 and 50 000 Lux is only 259 mV. Thus, the solar cell unit generates a voltage varying less than 300 mV in an open circuit when the light intensity received by the light-absorbing layer is varying between 200 and 50 000 Lux. Accordingly, the difference in generated voltage between 200 and 50 000 Lux is about 37%.

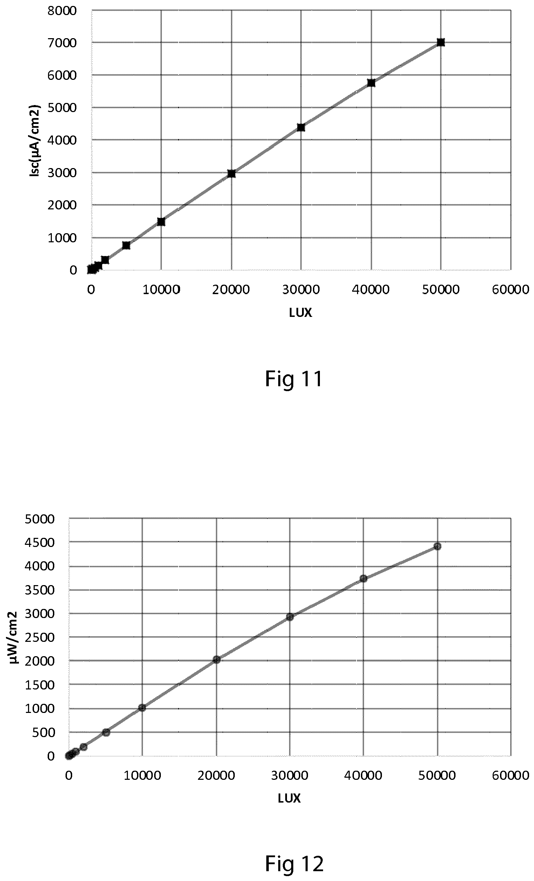

Figure 11 shows a diagram of generated current (µA/cm²) for light intensities between 200 and 50 000 Lux based on the measured values of table 2. As seen from the figure, the current increases linearly.

Figure 12 shows a diagram of generated power per area (µW/cm²) for light intensities between 200 and 50 000 Lux calculated based on the measured values of voltage and current of table 1. As seen from the diagram, the measured power is substantially proportional to the incoming light intensity in the interval 200 - 20 000 Lux.

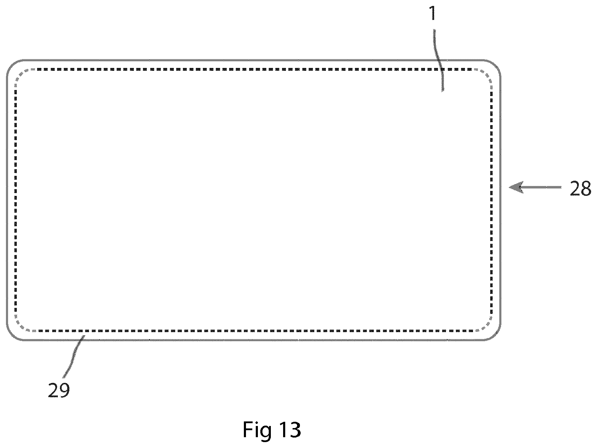

Figure 13 shows an example of a C 28 comprising a rechargeable battery (not shown), a casing 29 and a photovoltaic charger 1 for charging the battery integrated in the casing 29. The photovoltaic charger 1 can be of the type 1a or 1b. The tablet is shown in a view from above. The shape and size of the solar cell unit 2 of the photovoltaic charger is adapted to the size and shape of an upper surface of the casing 29. For example, the size of the solar cell unit is 15 x 20 cm, or 20 x 30 cm. The top surface of the photovoltaic charger is homogeneous, and there are no conductors visible on the surface of the photovoltaic charger. The solar cell unit of the photovoltaic charger may entirely cover the top surface of the casing, or it may end at a distance from the edges of the casing, as illustrated by dotted lines in the figure. If the photovoltaic charger 1a shown in figure 5 is used, the first conductor 18 is arranged along one of the edges of the encapsulation and can easily be covered and thus is not visible for the user. The output terminals of the boost converter 22 are connected to the rechargeable battery of the tablet.

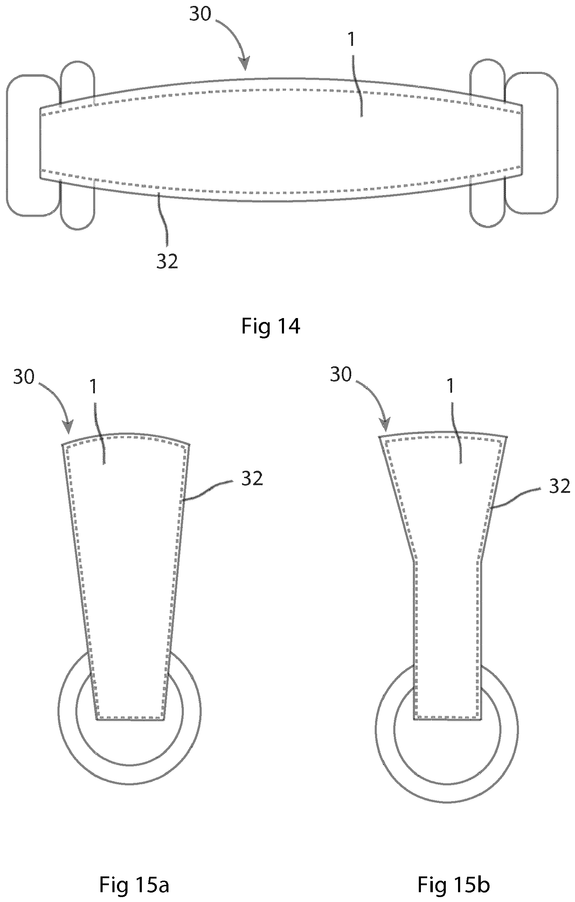

Figures 14 and 15a-b show an example of head phones 30 comprising a headband 32 having a photovoltaic charger 1 arranged on a top surface of the headband. Figure 14 shows a view from above of the head phones 30 and figures 15a-b show side views of the head phones. The head phones comprise a rechargeable battery (not shown), and the output terminals of the boost converter 22 is connected to the battery so that the battery is charged by the photovoltaic charger. The shape and size of the solar cell unit 2 of the photovoltaic charger is adapted to the size and shape of the headband 32 of the head phones. For example, the size of the solar cell unit 2 is 1.5 x 25 cm. The top surface of the photovoltaic charger is homogeneous, and there are no conductors visible on the surface of the photovoltaic charger. The output terminals of the boost converter 22 are connected to a rechargeable battery of the headband.

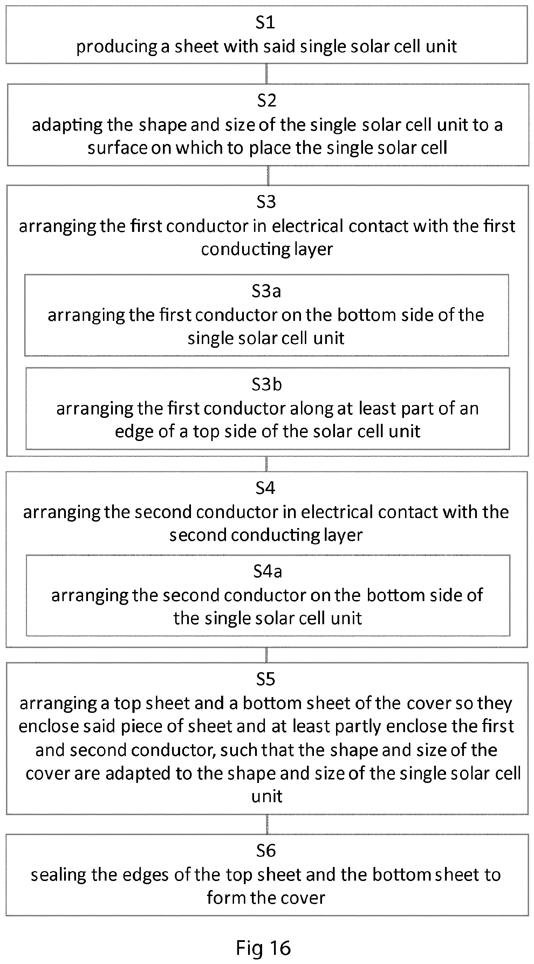

Figure 16 shows a flow diagram of a method for producing the photovoltaic charger. The method comprises producing S1 a sheet with a single solar cell unit. There are several possible variations to the solar cell unit and in how to produce it. In addition to the details disclosed here, published patent application WO2013149787 (A1) and WO2014184379 (A1) and well as unpublished EP application EP17209762.8 describe how to produce the solar cell unit 2. Accordingly, the three documents are herein disclosed by reference.

The method further comprises adapting S2 the shape and size of the single solar cell unit to a surface on which to place the single solar cell unit by cutting a piece of the sheet with the single solar cell unit into said shape and size. Any shape and size according to the limitations discussed above are possible. The single solar cell unit can thus be cut to a shape that the designer of a product chooses.

The method further comprises arranging S3 the first conductor in electrical contact with the first conducting layer and arranging S4 the second conductor in electrical contact with the second conducting layer. Alternatives for how the first and second conductors are arranged have been previously discussed.

The method further comprises arranging S5 a top sheet and a bottom sheet of the encapsulation, so they enclose said piece of sheet and at least partly enclose the first and second conductors, such that the shape and size of the encapsulation are adapted to the shape and size of the single solar cell unit.

The method further comprises sealing S6 the edges of the top sheet and the bottom sheet to form the encapsulation. The sides of the top sheet and bottom sheet facing the piece of sheet may be adhesive such when they are arranged over the sheet, they stick to the sheet. The top sheet and bottom sheet are, according to some aspects, larger than the piece of sheet such that they adhere to each other at the ends. According to some aspects, an adhesive may be put on the sheets instead of them being adhesive.

The method further comprises arranging S3a, S4a the first and second conductors on the bottom side of the single solar cell unit. Where they should be arranged has been previously discussed. Alternatively, the method comprises arranging S3b, S4a the first conductor along at least part of an edge of a top side of the solar cell unit and arranging at least one second conductor on a bottom side of the single solar cell unit. On which side the first conductor is arranged is up to the system designer.

According to some aspects, arranging S3 the first conductor in electrical contact with the first conducting layer and arranging S4 the second conductor in electrical contact with the second conducting layer comprises attaching the first conductor to the top sheet 5a or a bottom sheet 5b and attaching the second conductor to the bottom sheet 5b before arranging S5 the top sheet and a bottom sheet of the encapsulation. Thus, the first and second conductors are arranged in place at the same time as the top and bottom sheets are arranged. The at least one first conductor is then attached to the top sheet 5a or the bottom sheet 5b such that it is in electrical contact with the first conducting layer when the encapsulation is formed and wherein the at least one second conductor is attached to the bottom sheet 5b such that it is in electrical contact with the second conducting layer when the cover is formed. The method provides a way to produce the device where there is no need for any adhesive material between the first and second conductors and the first and second conducting layers. It is also easy to handle the thin conductors when they are attached to the surfaces of the encapsulation. In other words, when producing the photovoltaic device, the solar cell unit is provided and when the first and second conductors are to be arranged on the solar cell unit, they are first put on the corresponding location on the top sheet 5a and bottom sheet 5b such that when the top sheet 5a and the bottom sheet 5b are arranged on the solar cell unit, the first and second conductors are collocated to their positions on the solar cell unit.

The present invention is not limited to the embodiments disclosed but may be varied and modified within the scope of the following claims. For example, porous substrate may comprise a first portion including a network of conducting particles accommodated in the pores of the porous substrate, and a second portion without conducting particles in order to reduce the distance between the counter electrode and the light-absorbing layer. The photovoltaic device may comprise more than one second conductor arranged between the encapsulation and the solar cell unit. The photovoltaic device may also comprise more than one first conductor arranged between the encapsulation and the solar cell unit.

### Reference list

- 1, 1a, 1b: Photovoltaic charger
- 2: Solar cell unit
- 3: first connection element
- 4: second connection element
- 5: Encapsulation
- 5a: top sheet
- 5b: bottom sheet
- 7a-b: Penetrations
- 10: light absorbing layer
- 12: first conducting layer
- 14: porous substrate
- 16: second conducting layer
- 18: First conductor
- 20: Second current collector
- 22: Boost converter
- 24: Insulating gap
- 26: Through holes
- 28: Tablet
- 29: Casing
- 30: Head phones
- 32: Headband

## Claims

1. A photovoltaic charger (1;1a;1b) specially adapted for charging an electronic device, comprising:
• a solar cell unit (2) comprising:
- a working electrode comprising a porous light-absorbing layer (10) including dyed TiO₂,
- a porous first conducting layer (12) for extracting photo-generated electrons from the light-absorbing layer (10), wherein the light-absorbing layer is arranged on top of the first conducting layer,
- a porous substrate (14) made of an insulating material and extending through the entire solar cell unit, wherein the first conducting layer (12) is formed on one side of the porous substrate (14),
- a counter electrode including a second conducting layer (16), wherein the second conducting layer is formed on the opposite side of the porous substrate (14), and
- a conducting medium for transferring charges between the counter electrode and the light-absorbing layer,
• an encapsulation (5) encapsulating the solar cell unit,
• a first conductor (18) electrically connected to the first conducting layer (12), and
• at least one second conductor (20) electrically connected to the second conducting layer (16),
wherein the photovoltaic charger contains only one single solar cell unit (2) and a boost converter (22) electrically connected to the first and second conductors (12, 16), and the boost converter is adapted to step up the voltage from the solar cell unit while stepping down the current from the solar cell unit.

2. The photovoltaic charger according to claim 1, wherein the boost converter (22) is configured to convert the voltage from the solar cell unit (2) to a voltage that lies between 1 and 10 V.

3. The photovoltaic charger according to claim 1, wherein the boost converter is capable of converting a voltage between 0.25 and 1 V to a voltage above 3 V, and preferably above 3.5 V.

4. The photovoltaic charger according to any of the previous claims, wherein the solar cell unit (2) produces at least 5 µW/cm² when the light intensity received by the light-absorbing layer is 200 Lux, and at least 600 µW/cm² when the light intensity received by the light-absorbing layer is 20 000 Lux

5. The photovoltaic charger according to any of the previous claims, wherein the solar cell unit (2) produces at least 150 µW/cm² when the light intensity received by the light-absorbing layer is 5 000 Lux.

6. The photovoltaic charger according to any of the previous claims, wherein the solar cell unit (2) generates a voltage varying less than 40% when the light intensity received by the light-absorbing layer is varying between 200 and 50 000 Lux.

7. The photovoltaic charger according to any of the previous claims, wherein the solar cell unit (2) produces a current of at least 15 µA/cm² when the light intensity received by the light-absorbing layer is 200 Lux, and the current produced by the solar cell unit is linearly increasing when the light intensity received by the light-absorbing layer increases from 200 to 20 000 Lux.

8. The photovoltaic charger according to any of the previous claims, wherein the first and second conducting layers (12, 16) comprise metal or a metal alloy.

9. The photovoltaic charger according to any of the previous claims, wherein the porous substrate (14) is a sheet comprising woven microfibers extending through the entire solar cell unit.

10. The photovoltaic charger according to any of the previous claims, wherein the appearance of the top side of the solar cell unit (2) is homogenous.

11. The photovoltaic charger according to any of the previous claims, wherein the shortest distance (d) from side to side of the active area of the solar cell unit (2) is larger than 1 cm.

12. The photovoltaic charger according to any of the previous claims, wherein the shortest distance (d) from side to side of the active area of the solar cell unit (2) is larger than 10 cm.

13. The photovoltaic charger according to any of the previous claims, wherein the conducting medium is a liquid electrolyte.

14. Use of the photovoltaic charger according to any of the claims 1 - 12 for powering a portable electronic device (28; 30), wherein the shape and size of the single solar cell unit (2) is adapted to the size and shape of the portable electronic device it is powering.

15. Use of the photovoltaic charger according to any of the claims 1 - 12, wherein the portable electronic is head phones (30) comprising a headband (32) for reaching over a wearer's head, and the photovoltaic charger (1) is arranged on a top surface of the headband.

16. Use of the photovoltaic charger according to any of the claims 1 - 12, wherein the portable electronic device is a tablet (28), and the photovoltaic charger (1) is integrated in a casing (29) of the tablet.

17. Method for producing the photovoltaic charger according to any of the claims 1 - 12, wherein the method comprises:
• producing a sheet with said single solar cell unit (S1),
• adapting the shape and size of the single solar cell unit to a surface on which to place the single solar cell unit by cutting a piece of the sheet with the single solar cell unit into said shape and size (S2),
• arranging the first conductor in electrical contact with the first conducting layer (S3),
• arranging the second conductor in electrical contact with the second conducting layer (S4),
• arranging a top sheet and a bottom sheet of the encapsulation so they enclose said piece of sheet and at least partly enclose the first and second conductors, such that the shape and size of the encapsulation are adapted to the shape and size of the single solar cell unit (S5), and
• sealing the edges of the top sheet and the bottom sheet to form the encapsulation (S6).
